# EUROPEAN PATENT APPLICATION

(11) **EP 4 379 504 A1**
(43) Date of publication of application: **05.06.2024**
(21) Application number: 23213424.7
(22) Date of filing: 30.11.2023
(51) Int. Cl.: G06F 1/20

(54) **HEAT TRANSFER DEVICES FOR ENHANCED THERMAL PERFORMANCE OF ELECTRONIC SYSTEMS**

(30) Priority: 30.11.2022 US 202263429025 P; 15.11.2023 US 202318510602
(71) Applicant: MICRON TECHNOLOGY, INC., Boise, Idaho 83716 (US)
(72) Inventor: KOLLIPARA, Ravi Kumar, 500089 Telangana (IN); SUBHASH, Deepu Narasimiah, 560022 Bangalore (IN); YARRAGUNTA, Suresh Reddy, 560059 Bangalore (IN)
(74) Representative: Marks & Clerk LLP

(57) **Abstract**

A system with a circuit with components, an enclosure with a top and a bottom, and a heat transfer device. The heat transfer device has an exterior surface with a first portion, a second portion, and a third portion, where the first portion faces opposite the second portion; and an interior surface with a fourth portion, a fifth portion, and a sixth portion, where the fourth portion faces the fifth portion. The first portion configured to thermally couple to the top of the enclosure. The second portion configured to thermally couple to the bottom of the enclosure. The fourth portion configured to couple to a component mounted on a primary side of the circuit board. The fifth portion configured to face a secondary side of the circuit board. The first heat transfer device configured to distribute thermal energy generated from a component to the top and bottom of the enclosure.

## Description

### TECHNICAL FIELD

Embodiments of the disclosure relate generally to electronic systems, and more specifically, relate to heat transfer devices for enhanced thermal performance of electronic systems.

### BACKGROUND

A memory sub-system can include one or more memory devices that store data. The memory devices can be, for example, non-volatile memory devices and volatile memory devices. In general, a host system can utilize a memory sub-system to store data at the memory devices and to retrieve data from the memory devices.

### BRIEF DESCRIPTION OF THE DRAWINGS

The disclosure will be understood more fully from the detailed description given below and from the accompanying drawings of various embodiments of the disclosure. The drawings, however, should not be taken to limit the disclosure to the specific embodiments, but are for explanation and understanding only.
**FIG. 1** illustrates an example computing system that includes a memory sub-system, in accordance with some embodiments of the present disclosure.
**FIG. 2A** and **FIG. 2B** illustrate examples of a heat transfer device, in accordance with some embodiments.
**FIG. 3** illustrates an example embodiment of a heat transfer device, in accordance with some embodiments.
**FIG. 4** illustrates an example embodiment of a system with a heat transfer device, in accordance with some embodiments.
**FIG. 5A** illustrates thermal scans of an example embodiment in operation without a heat transfer device, in accordance with some embodiments.
**FIG. 5B** illustrates thermal scans of an example embodiment in operation with a heat transfer device, in accordance with some embodiments.
**FIG. 6A** illustrates thermal scans of an example embodiment in operation with a heatsink, but without a heat transfer device, in accordance with some embodiments.
**FIG. 6B** illustrates thermal scans of an example embodiment in operation with a heatsink, and a heat transfer device, in accordance with some embodiments.

### DETAILED DESCRIPTION

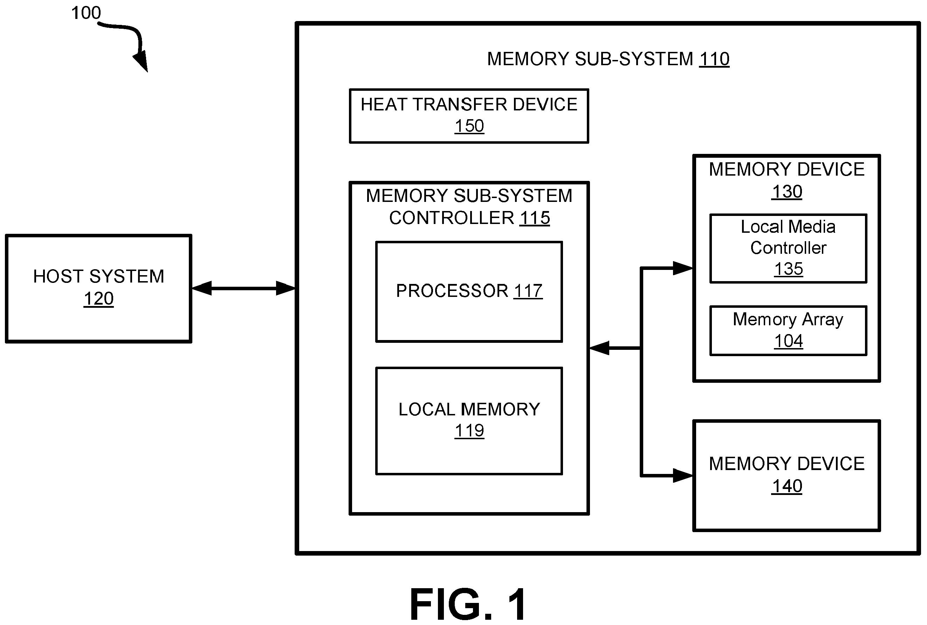

Aspects of the present disclosure are directed to heat transfer device for electronic systems, such as memory sub-systems. A memory sub-system can be a storage device, a memory module, or a combination of a storage device and memory module. Examples of storage devices and memory modules are described below in conjunction with FIG. 1. In general, a host system can utilize a memory sub-system that includes one or more components, such as memory devices that store data. The host system can provide data to be stored at the memory sub-system and can request data to be retrieved from the memory sub-system.

Electronics, such as memory devices and computer components, can generate thermal energy during operation. In electronic systems, electronic component density continues to increase (e.g., the density of components mounted to a circuit board or printed circuit board (PCB) increases) such that the thermal energy generated by electronics and their subcomponents may impact the performance, function, and/or reliability of the electronic system. Additionally, electronic systems can include standardized enclosures that can inhibit the efficient distribution and removal of thermal energy from the electronic system. Due to the inefficiencies of thermal energy removal of some standardized enclosures, the layout of components on the circuit board can be sub-optimal (e.g., less flexibility to mount components on the PCB).

For example, some high-power memory sub-systems can have components mounted on the primary side and on the secondary side of the circuit board. A "primary side" (also referred to as a "top side") of the circuit board may refer to a top-most side of a circuit board substrate above which one or more functional electronic devices can be mounted. A "secondary side" of the circuit board may refer to the bottom-most side of the circuit substrate. In some cases, the bottom secondary side can include multiple electrical contacts or through holes. In some cases, electrical components can be mounted to the secondary side of the circuit board. In some cases, one or more inner layers can be disposed between the primary side and the secondary side of the circuit board substrate. A standardized enclosure that encloses at least part (often a majority) of the circuit board may not be symmetric. For instance, an enclosure may have a heatsink with fins on a top side of the enclosure and have a solid metal planar surface on the bottom side of the enclosure. The bottom side of the enclosure may have less surface area and less ability to exchange thermal energy (e.g., heat) than the top side of the enclosure with greater surface area. With the above given geometry of the enclosure, the highest heat producing components can be placed on the primary surface of the circuit board, which is adjacent to the top side of the enclosure. Lower heat producing components can be placed on the secondary side of the circuit board, which is adjacent to the bottom side of the enclosure. Such a layout may not take advantage of the entire area (e.g., primary and secondary sides) of the circuit board and may be sub-optimal from a component routing perspective. For instance, component routing complexity may be increased by placing components in thermally advantageous positions, instead of placing components in positions with routing or signal integrity advantages. Additionally, in the aforementioned enclosure geometries and associated component layouts, the circuit board can generate an unbalanced thermal load, which may be distributed to the enclosure in an unbalanced manner (which may cause inefficient thermal removal).

Aspects of the present disclosure address the above and other deficiencies by having a bent or curved shaped heat transfer device configured to thermally couple to the top portion (e.g. top side) of the enclosure, the bottom portion (e.g., bottom side) of the enclosure, and one or more electrical components mounted on the primary side of the circuit board of an electronic system and in some embodiments, one more electrical components mounted on the secondary side of the circuit board. In some embodiments, multiple heat transfer devices can be used in an electronic system. For instance, a first heat transfer device can thermally couple to an electrical component(s) mounted to one half of the circuit board (and mounted to the primary side, the secondary side or both), and a second heat transfer device can thermally couple to another electrical component(s) mounted to the opposite half of the circuit board (and mounted to the primary side, the secondary side or both). Both the first and the second heat transfer devices can be thermally coupled to the top portion and the bottom portion of the enclosure.

The aspects of the disclosure described herein may more evenly distribute the thermal energy generated by the electrical components of an electronic system to the top portion and/or bottom portion of the enclosure. By efficiently transferring thermal energy away from electrical components on the primary or secondary side of a circuit board in the electronic component, localized concentrations of thermal energy can be reduced, and electronic component reliability, consistency, performance, and lifespan can be increased. In some instances, the heat transfer device may more efficiently transfer thermal energy away from thermal energy sources that have traditionally been difficult to reach (e.g., components mounted on the secondary side of a circuit board) to an enclosure or attached heatsink with a larger surface area. The heat transfer device may more evenly distribute the thermal energy of an electronic system by better thermal coupling between heat generating components and the surface of the enclosure, which can increase the effective surface area available for passive distribution of thermal energy by thermal convection. A heat transfer device may improve isothermal cooling of components by more efficiently balancing the heat transfer of components mounted on multiple sides of a PCB. The heat transfer device may allow the circuit board and attached components to handle higher thermal loads by improving overall thermal efficiency of the device system. The heat transfer device may also reduce design complexities associated with thermal load and circuit board trace calculations, and provide additional flexibility for placement of components on the circuit board (e.g., heat-generating components can be placed and routed on either the primary side or secondary side of the circuit board irrespective of their respective thermal generation characteristics).

It may be noted that for purposes of illustration, rather than limitation, the heat transfer device is described as implemented with a memory sub-system. In other embodiments, the heat transfer device may be used with other systems with electrical components.

A memory sub-system can include high density non-volatile memory devices where retention of data is desired when no power is supplied to the memory device. One example of non-volatile memory devices is a not-and (NAND) memory device. Other examples of non-volatile memory devices are described below in conjunction with FIG. 1. A non-volatile memory device is a package of one or more dies. Each die may include one or more planes. For some types of non-volatile memory devices (e.g., NAND devices), each plane includes a set of physical blocks. Each block includes a set of pages. Each page includes a set of memory cells ("cells"). A cell is an electronic circuit that stores information. Depending on the cell type, a cell can store one or more bits of binary information, and has various logic states that correlate to the number of bits being stored. The logic states can be represented by binary values, such as "0" and " 1", or combinations of such values.

A memory device can be made up of bits arranged in a two-dimensional or a three-dimensional grid. Memory cells are formed onto a silicon wafer in an array of columns (also hereinafter referred to as bitlines) and rows (also hereinafter referred to as wordlines). A wordline can have a row of associated memory cells in a memory device that are used with one or more bitlines to generate the address of each of the memory cells. The intersection of a bitline and wordline constitutes the address of the memory cell. A block hereinafter refers to a unit of the memory device used to store data and can include a group of memory cells, a wordline group, a wordline, or individual memory cells. One or more blocks can be grouped together to form separate partitions (e.g., planes) of the memory device in order to allow concurrent operations to take place on each plane. The memory device can include circuitry that performs concurrent memory page accesses of two or more memory planes. For example, the memory device can include multiple access line driver circuits and power circuits that can be shared by the planes of the memory device to facilitate concurrent access of pages of two or more memory planes, including different page types. For ease of description, these circuits can be generally referred to as independent plane driver circuits. Depending on the storage architecture employed, data can be stored across the memory planes (i.e., in stripes). Accordingly, one request to read a segment of data (e.g., corresponding to one or more data addresses), can result in read operations performed on two or more of the memory planes of the memory device.

The following figure descriptions include the terms, "couple" or "coupling." "Coupling" may refer to thermal coupling and/or mechanical coupling and/or electrical coupling, either directly or indirectly. "Thermal coupling" may refer to a connection of two or more object such that the two or more objects, in direct or indirect contact, can transmit thermal energy by thermal conduction, unless otherwise described (e.g., by thermal convection). "Direct thermal coupling" may refer to thermal coupling between two or more objects, in direct contact, where thermal energy is transmitted by thermal conduction. "Mechanical coupling" may refer to a direct or indirect physical connection between two or more objects. "Direct mechanical coupling" may refer to a direct physical connection between two or more adjacent object (e.g., touching).

**FIG. 1** illustrates an example computing system 100 that includes a memory sub-system 110 in accordance with some embodiments of the present disclosure. The memory sub-system 110 can include media, such as one or more volatile memory devices (e.g., memory device 140), one or more non-volatile memory devices (e.g., memory device 130), or a combination of such.

A memory sub-system 110 can be a storage device, a memory module, or a combination of a storage device and memory module. Examples of a storage device include a solid-state drive (SSD), a flash drive, a universal serial bus (USB) flash drive, an embedded Multi-Media Controller (eMMC) drive, a Universal Flash Storage (UFS) drive, a secure digital (SD) card, and a hard disk drive (HDD). Examples of memory modules include a dual in-line memory module (DIMM), a small outline DIMM (SO-DIMM), and various types of non-volatile dual in-line memory modules (NVDIMMs).

The computing system 100 can be a computing device such as a desktop computer, laptop computer, network server, mobile device, a vehicle (e.g., airplane, drone, train, automobile, or other conveyance), Internet of Things (IoT) enabled device, embedded computer (e.g., one included in a vehicle, industrial equipment, or a networked commercial device), or such computing device that includes memory and a processing device.

The computing system 100 can include a host system 120 that is coupled to one or more memory sub-systems 110. In some embodiments, the host system 120 is coupled to multiple memory sub-systems 110 of different types. **FIG. 1** illustrates one example of a host system 120 coupled to one memory sub-system 110. As used herein, "coupled to" or "coupled with" generally refers to a connection between components, which can be an indirect communicative connection or direct communicative connection (e.g., without intervening components), whether wired or wireless, including connections such as electrical, optical, magnetic, etc.

The host system 120 can include a processor chipset and a software stack executed by the processor chipset. The processor chipset can include one or more cores, one or more caches, a memory controller (e.g., NVDIMM controller), and a storage protocol controller (e.g., PCIe controller, SATA controller). The host system 120 uses the memory sub-system 110, for example, to write data to the memory sub-system 110 and read data from the memory sub-system 110.

The host system 120 can be coupled to the memory sub-system 110 via a physical host interface. Examples of a physical host interface include, but are not limited to, a serial advanced technology attachment (SATA) interface, a peripheral component interconnect express (PCIe) interface, universal serial bus (USB) interface, Fibre Channel, Serial Attached SCSI (SAS), a double data rate (DDR) memory bus, Small Computer System Interface (SCSI), a dual in-line memory module (DIMM) interface (e.g., DIMM socket interface that supports Double Data Rate (DDR)), etc. The physical host interface can be used to transmit data between the host system 120 and the memory sub-system 110. The host system 120 can further utilize an NVM Express (NVMe) interface to access components (e.g., memory devices 130) when the memory sub-system 110 is coupled with the host system 120 by the physical host interface (e.g., PCIe bus). The physical host interface can provide an interface for passing control, address, data, and other signals between the memory sub-system 110 and the host system 120. **FIG. 1** illustrates a memory sub-system 110 as an example. In general, the host system 120 can access multiple memory sub-systems via a same communication connection, multiple separate communication connections, and/or a combination of communication connections.

The memory devices 130, 140 can include any combination of the different types of non-volatile memory devices and/or volatile memory devices. The volatile memory devices (e.g., memory device 140) can be, but are not limited to, random access memory (RAM), such as dynamic random access memory (DRAM) and synchronous dynamic random access memory (SDRAM).

Some examples of non-volatile memory devices (e.g., memory device 130) include a not-and (NAND) type flash memory and write-in-place memory, such as a three-dimensional cross-point ("3D cross-point") memory device, which is a cross-point array of non-volatile memory cells. A cross-point array of non-volatile memory cells can perform bit storage based on a change of bulk resistance, in conjunction with a stackable cross-gridded data access array. Additionally, in contrast to many flash-based memories, cross-point non-volatile memory can perform a write in-place operation, where a non-volatile memory cell can be programmed without the non-volatile memory cell being previously erased. NAND type flash memory includes, for example, two-dimensional NAND (2D NAND) and three-dimensional NAND (3D NAND).

Each of the memory devices 130 can include one or more arrays of memory cells. One type of memory cell, for example, single level cells (SLC) can store one bit per cell. Other types of memory cells, such as multi-level cells (MLCs), triple level cells (TLCs), quad-level cells (QLCs), and penta-level cells (PLCs) can store multiple bits per cell. In some embodiments, each of the memory devices 130 can include one or more arrays of memory cells such as SLCs, MLCs, TLCs, QLCs, PLCs or any combination of such. In some embodiments, a particular memory device can include an SLC portion, and an MLC portion, a TLC portion, a QLC portion, or a PLC portion of memory cells. The memory cells of the memory devices 130 can be grouped as pages that can refer to a logical unit of the memory device used to store data. With some types of memory (e.g., NAND), pages can be grouped to form blocks.

Although non-volatile memory components such as a 3D cross-point array of non-volatile memory cells and NAND type flash memory (e.g., 2D NAND, 3D NAND) are described, the memory device 130 can be based on any other type of non-volatile memory, such as read-only memory (ROM), phase change memory (PCM), self-selecting memory, other chalcogenide based memories, ferroelectric transistor random-access memory (FeTRAM), ferroelectric random access memory (FeRAM), magneto random access memory (MRAM), Spin Transfer Torque (STT)-MRAM, conductive bridging RAM (CBRAM), resistive random access memory (RRAM), oxide based RRAM (OxRAM), not-or (NOR) flash memory, or electrically erasable programmable read-only memory (EEPROM).

A memory sub-system controller 115 (or controller 115 for simplicity) can communicate with the memory devices 130 to perform operations such as reading data, writing data, or erasing data at the memory devices 130 and other such operations. The memory sub-system controller 115 can include hardware such as one or more integrated circuits and/or discrete components, a buffer memory, or a combination thereof. The hardware can include a digital circuitry with dedicated (i.e., hard-coded) logic to perform the operations described herein. The memory sub-system controller 115 can be a microcontroller, special purpose logic circuitry (e.g., a field programmable gate array (FPGA), an application specific integrated circuit (ASIC), etc.), or other suitable processor.

The memory sub-system controller 115 can include a processing device, which includes one or more processors (e.g., processor 117), configured to execute instructions stored in a local memory 119. In the illustrated example, the local memory 119 of the memory sub-system controller 115 includes an embedded memory configured to store instructions for performing various processes, operations, logic flows, and routines that control operation of the memory sub-system 110, including handling communications between the memory sub-system 110 and the host system 120.

In some embodiments, the local memory 119 can include memory registers storing memory pointers, fetched data, etc. The local memory 119 can also include read-only memory (ROM) for storing micro-code. While the example memory sub-system 110 in **FIG. 1** has been illustrated as including the memory sub-system controller 115, in another embodiment of the present disclosure, a memory sub-system 110 does not include a memory sub-system controller 115, and can instead rely upon external control (e.g., provided by an external host, or by a processor or controller separate from the memory sub-system).

In general, the memory sub-system controller 115 can receive commands or operations from the host system 120 and can convert the commands or operations into instructions or appropriate commands to achieve the desired access to the memory devices 130. The memory sub-system controller 115 can be responsible for other operations such as wear leveling operations, garbage collection operations, error detection and error-correcting code (ECC) operations, encryption operations, caching operations, and address translations between a logical address (e.g., a logical block address (LBA), namespace) and a physical address that are associated with the memory devices 130. The memory sub-system controller 115 can further include host interface circuitry to communicate with the host system 120 via the physical host interface. The host interface circuitry can convert the commands received from the host system into command instructions to access the memory devices 130 as well as convert responses associated with the memory devices 130 into information for the host system 120.

The memory sub-system 110 can also include additional circuitry or components that are not illustrated. In some embodiments, the memory sub-system 110 can include a cache or buffer (e.g., DRAM) and address circuitry (e.g., a row decoder and a column decoder) that can receive an address from the memory sub-system controller 115 and decode the address to access the memory devices 130.

In some embodiments, the memory devices 130 include local media controllers 135 that operate in conjunction with memory sub-system controller 115 to execute operations on one or more memory cells of the memory devices 130. An external controller (e.g., memory sub-system controller 115) can externally manage the memory device 130 (e.g., perform media management operations on the memory device 130). In some embodiments, memory sub-system 110 is a managed memory device, which is a raw memory device 130 having control logic (e.g., local media controller 135) on the die and a controller (e.g., memory sub-system controller 115) for media management within the same memory device package. An example of a managed memory device is a managed NAND (MNAND) device.

In some embodiments, the memory sub-system 110 can include a heat transfer device 150 that can distribute localized heat generated by memory sub-system 110 more uniformly across memory sub-system 110. Memory sub-system 110 can be enclosed in an enclosure, and heat transfer device 150 can transfer thermal energy (e.g., heat generated as a byproduct of normal operation) from the components of the memory sub-system 110 to the enclosure. Heat transfer device 150 may be mechanically and/or thermally coupled to memory sub-system 110, memory sub-system control 115, processor 117, local memory 119, memory device 130, local media controller 135, memory array 104, or memory device 140. In many embodiments, physical components that make up memory sub-system 110 may be distributed across a circuit board, including on one or more sides of the circuit board (e.g., on a "primary" and "secondary" side of a circuit board). Heat transfer device 150 may be configured to distribute thermal energy generated by sub-components of memory sub-system 110 more uniformly to the enclosure of a memory sub-system 110 to reduce localized areas of high thermal energy, as described in more detail below.

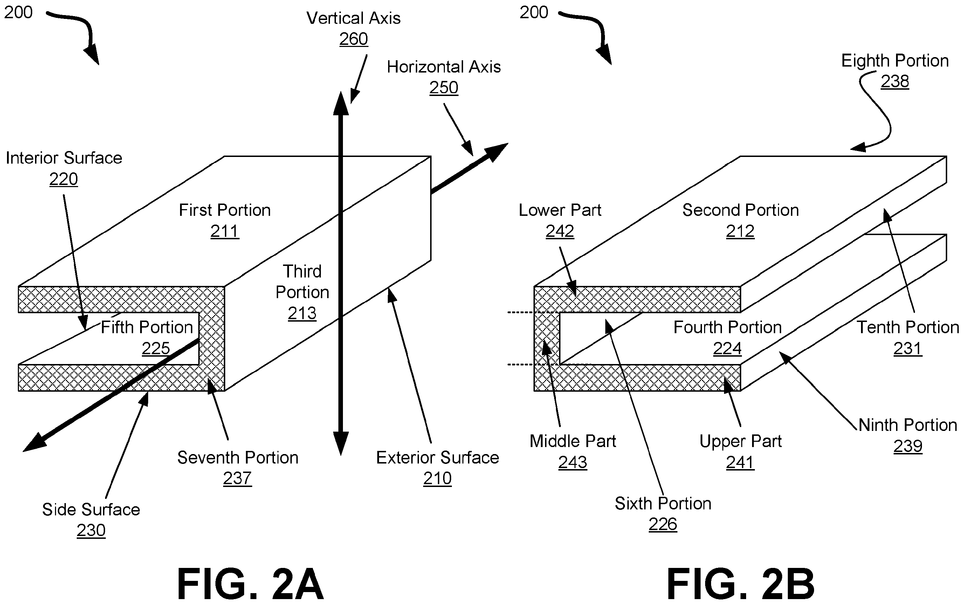

**FIG. 2A** and **FIG. 2B** illustrate example embodiments of heat transfer device 200, in accordance with some embodiments. **FIG. 2A** shows a top view of heat transfer device 200, while **FIG. 2B** shows a bottom view of heat transfer device 200. Heat transfer device 200 has an exterior surface 210 with first portion 211, second portion 212, and third portion 213. Heat transfer device 200 has an interior surface 220 with fourth portion 224, fifth portion 225, and sixth portion 226. Heat transfer device 200 has a side surface 230 which connects the exterior surface 210 to the interior surface 220 with seventh portion 237, eighth portion 238 (not visible), ninth portion 239, and tenth portion 231. Heat transfer device 200 may also be described or represented by upper part 241, middle part 243, and lower part 242. Upper part 241 can include a three-dimensional shape with approximate boundaries as shown of first portion 211, ninth portion 239, fourth portion 224, slices of seventh portion 237 and eighth portion 238, and a slice of third portion 213. Upper part 241 is a three-dimensional shape with approximate boundaries as shown of second portion 212, tenth portion 231, fifth portion 225, slices of seventh portion 237 and eighth portion 238, and a slice of third portion 213. Middle part 243 is a three-dimensional shape with approximate boundaries as shown of sixth portion 226, third portion 213, slices of seventh portion 237 and eighth portion 238, upper boundary of upper part 241, and lower boundary of lower part 242. In most embodiments, heat transfer device 200 may be configured to efficiently transfer heat throughout heat transfer device 200. In many embodiments, heat transfer device 200 may resemble a bent or curved shape. In some embodiments, heat transfer device may have a "folded-over" structure, with first portion 211 and second portion 212 of the exterior surface 210 substantially parallel to fourth portion 224 and fifth portion 225 of the interior surface 220, respectively. In certain embodiments, seventh portion 237 may connect first portion 211 and fourth portion 224; eighth portion 238 may connect the second portion 212 and fifth portion 225; and ninth portion 239 and tenth portion 231 may connect like "endcaps" at each end of the first-eighth portions (e.g., ninth portion 239 and tenth portion 231 endpieces may resemble the "folded over" profile of heat transfer device 200 as may be seen with respect **FIG. 2A** and **FIG. 2B**). In some embodiments, the curved shape of the heat transfer device 200 is configured to fit within an enclosure of an electronic system. In some embodiments, heat transfer device 200 may resemble another shape conducive to distributing heat from components of primary side and/or secondary side of a circuit board to the top portion and/or bottom portion of the enclosure.

In many embodiments, upper part 241 and lower part 243 may be a similar shape and/or size. In some embodiments, upper part 241 and lower part 243 may be a dissimilar shape and/or size. In many embodiments, upper part 241 may resemble a quadrilateral, a polygon, a circular or partially circular shape, etc. In many embodiments, middle part may resemble a quadrilateral, a polygon, a circular or partially circular shape, etc. In some embodiments, first portion 211, second portion 212, and third portion 213 of exterior surface 210 may have one or more bends or curves (not pictured). In some embodiments, bends, or curves in exterior surface 210 of heat transfer device 200 may allow exterior surface 210 to thermally couple with an enclosure (not pictured). In some embodiments, fourth portion 224, fifth portion 225, and sixth portion 226, may have one or more bends or curves (not pictured). In some embodiments, bends, or curves on interior surface 220 of heat transfer device 200 may allow interior surface 220 to thermally couple with a heat-generating object (e.g., a component mounted to a circuit board, etc.-not pictured). In many embodiments, upper part 241 and lower part 242 may be substantially symmetric about horizontal axis 250, which bisects sixth portion 226 halfway between fourth portion 224 and fifth portion 225. As used in the specification and claims, "substantially" may generally describe something is within ±10% of its comparator (e.g., a plane is substantially similar to another plane if it has an area within ±10% of the compared plane). Additionally, substantially may be used to describe the dimensions of an object (e.g., a length, width, and/or height) and/or may refer to volumes and other similar metrics or characteristics that provide meaningful comparators. In some embodiments, upper part 241 and lower part 242 may be asymmetric about horizontal axis 250. In many embodiments, upper part 241 and lower part 242 may be substantially symmetric about vertical axis 260, which bisect third portion 213 halfway between seventh portion 237 and eighth portion 238. In some embodiments, upper part 241 and lower part 242 may be asymmetric about vertical axis 260.

In some embodiments, upper part 241, lower part 242, and middle part 243, may be a solid piece of material. In some embodiments, upper part 241, lower part 242, and middle part 243, may be configured to transfer thermal energy from interior surface 220 (fourth portion 224, fifth portion 225, and sixth portion 226 respectively) to exterior surface 210 (first portion 211, second portion 212, and third portion 213 respectively). In some embodiments, heat transfer device 200 may be configured to transfer thermal energy from interior surface 220 to exterior surface 210 by thermal conduction. In some embodiments, heat transfer device 200 may be configured to transfer thermal energy from interior surface 220 to exterior surface 210 at least in part by thermal convection. In some embodiments, heat transfer device 200 may be configured to transfer thermal energy from upper part 241 to lower part 242. In some embodiments, heat transfer device 200 may be configured to transfer thermal energy from lower part 242 to upper part 241.

In some embodiments, upper part 241, lower part 242, and middle part 243, may have one or more hollow cavities (not pictured). In some embodiments, heat transfer device may have one continuous hollow cavity. In some embodiments, heat transfer device 200 may contain one or more internal surfaces within the hollow cavity. In certain embodiments, heat transfer device 200 may contain a liquid or gas (e.g., air, or a liquid or aerosol coolant) or a near-vacuum within the hollow cavity. In some embodiments, heat transfer device 200 may be configured to vaporize a liquid contained within a hollow cavity. In some embodiments, heat transfer device 200 may be configured as an isothermal heat-spreader by allowing a vaporized liquid within the hollow cavity to evenly dissipate throughout the cavity (e.g., a vapor chamber). In some embodiments, heat transfer device 200 may be configured with one or more condenser surfaces within a hollow cavity to allow vaporized liquid to condense back into a non-gaseous state. In some embodiments, the condenser surfaces within heat transfer device 200 may be passively or actively cooled by thermal convection, or by thermal conduction with a liquid or solid. In most embodiments, the vaporization and condensation processes may be configured to occur within heat transfer device 200, and may improve uniform distribution of thermal energy throughout heat transfer device 200. In some embodiments, thermal energy exchange processes may be configured to occur within heat transfer device 200, and may lower a localized and/or overall temperature of a heat-generating object coupled to heat transfer device 200. In many embodiments, the processes configured to occur within heat transfer device 200 may lower a thermal energy differential across multiple localized portions of a heat-generating object coupled to heat transfer device 200.

In many embodiments, heat transfer device 200 may be constructed such that heat transfer device fits within industry standard enclosures for memory devices and/or computer components (e.g., Serial AT Attachment (SATA)2.5", 3.5", and 5.25"; M.2 Non-Volatile Memory Express (NVMe), and SATA 2242, 2260, and 2280; Mini-SATA (mSATA); Half-Slim SATA or SlimSATA; Enterprise & Datacenter SSD Form Factors (EDSFF) E1.L, E1.S, E2.L, E2. S, E3.L and E3. S; other form factors developed by the Storage Networking Industry Association SSD Form Factor Technical Affiliate (SNIA-SFF-TA); add-in cards and various removable storage form factors; and Peripheral Component Interconnect Express (PCIe) components and other similar computer interface industry form factors).

In some embodiments, heat transfer device 200 may be formed from one or a mix of metallic materials (e.g., copper, titanium, aluminum, and/or magnesium, as well as other metallic materials). In some embodiments, heat transfer device 200 may formed from titanium. In some embodiments, heat transfer device 200 may be formed from one or mix of semiconductor or carbon-based materials (e.g., silicon, graphite, graphite, and other carbon or semiconductor-based materials). In some embodiments, heat transfer device 200 may formed from graphite. In some embodiments, graphite and/or titanium can be used for the materials thermal properties, strength and/or flexibility. In some embodiments, heat transfer device 200 may be formed from a mix thermally conductive materials, such as semiconductor or carbon-based materials, and metallic materials. In some embodiments, heat transfer device 200 may be flexible.

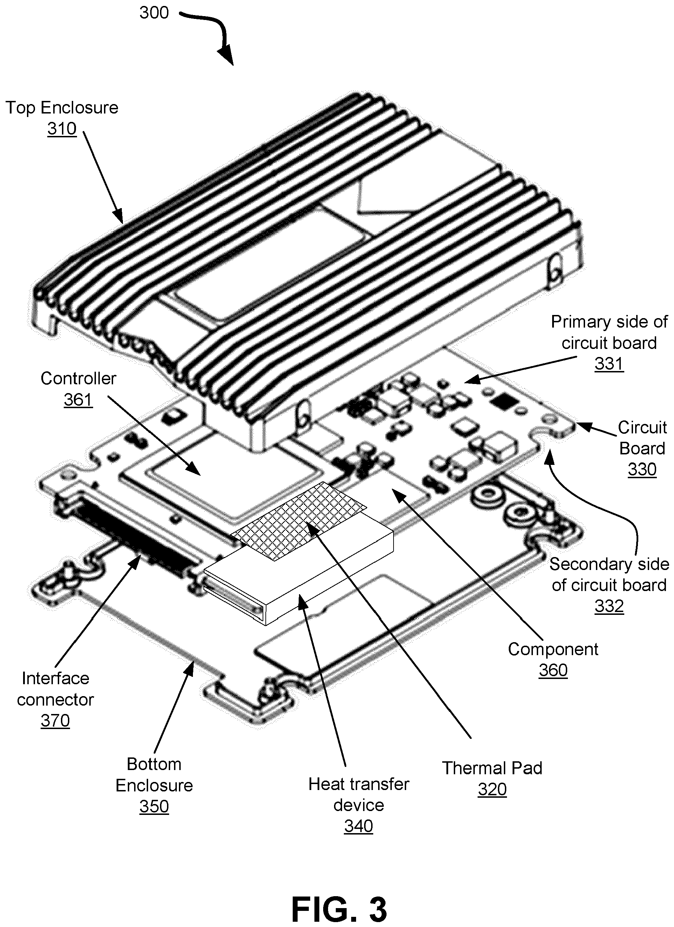

**FIG. 3** illustrates an example embodiment of heat transfer device 340, in accordance with some embodiments. System 300 (also referred to as "electronic system" herein) includes top enclosure 310, thermal pad 320, circuit board 330, heat transfer device 340, and bottom enclosure 350. Interface connector 370 is mechanically and electrically attached to circuit board 330. Circuit board 330 has a primary side 331, and a secondary side 332. Components 360 are mechanically, and often electrically, coupled to circuit board 330. Controller 361 is a certain component 360, and in this embodiment is mounted to primary side 331. Heat transfer device 340 may be a heat transfer device such as heat transfer device 200 as described with respect to **FIGs. 2A** and **2B****.** Heat transfer device 340 mechanically and thermally couples to components 360 (e.g., direct thermal coupling). Heat transfer device 340 mechanically and thermally couples to top enclosure 310 and bottom enclosure 350. Thermal pad 320 is positioned between and couples heat transfer device 340 and top enclosure 310. In some embodiments, the location of interface connector 370 may be determined by an industry standard.

In some embodiments, system 300 may be a memory system (e.g., a solid-state drive (SSD)). In some embodiments, system 300 may be a computer interface system (e.g., a peripheral component interconnect express (PCIe) card). In some embodiments, system 300 may have two or more heat transfer devices 340. In many embodiments, heat transfer device 340 may improve uniform distribution of thermal energy (e.g., heat) across system 300. In many embodiments, heat transfer device 340 may distribute heat from circuit board 330 to both top enclosure 310 and bottom enclosure 350. In many embodiments, heat transfer device 340 may distribute thermal energy from components 360 mounted to primary side 331 and/or secondary side 332 of circuit board 330 to both top enclosure 310 and bottom enclosure 350. In some embodiments, one heat transfer device 340 may couple to two or more circuit boards 330 (or two or more components 360) within system 300. In some embodiments, one heat transfer device 340 may couple to two or more top enclosures 310 and/or two or more bottom enclosures 350. In some embodiments, two or more heat transfer devices 340 may couple to circuit board 330. In some embodiments, one top enclosure 310 and or bottom enclosure 350 may couple to two or more heat transfer devices 340.

In some embodiments, heat transfer device 340 may be positioned inside an enclosure envelope consisting of top enclosure 310 and bottom enclosure 350. In some embodiments, heat transfer device 340 may form part of an enclosure envelope in conjunction with top enclosure 310 and bottom enclosure 350. In some embodiments part of heat transfer device 340, such as middle part 243 as described with respect to **FIG. 2A-2B****,** may be configured as a structural part of the enclosure envelope in conjunction with top enclosure 310 and bottom enclosure 350 (not pictured). In some embodiments, heat transfer device 340 may be a permanent fixture of either top enclosure 310 and/or bottom enclosure 350. In some embodiments, a heatsink (not pictured) may couple to one or both of top enclosure 310 and/or bottom enclosure 350. In some embodiments, a heatsink may be integrated with one or both of top enclosure 310 and/or bottom enclosure 350. In many embodiments, a heatsink may have a substantially larger surface area than either top enclosure 310 or bottom enclosure 350 (e.g., a heatsink may have rows of "fins," thereby increasing the effective surface area the heatsink has for dissipation of thermal energy by thermal convection).

In some embodiments, thermal pad 320 may be positioned between to heat transfer device 340 and top enclosure 310. In certain embodiments, thermal pad 320 may cover approximately 55-85% of a top surface of heat transfer device 340, such as first portion 211 of exterior surface 210 as described with respect to **FIG. 2A-2B****.** In some embodiments, heat transfer device 340 may thermally and/or mechanically couple to top enclosure 310 through thermal pad 320. In some embodiments, heat transfer device 340 may thermally and/or mechanically couple to bottom enclosure 350 through thermal pad 320. In some embodiment, interior surfaces of heat transfer device 340, such as fourth portion 224 and fifth portion 225 of interior surface 220 as described with respect to **FIG. 2A-2B****,** may be configured to mechanically and/or thermally couple to circuit board 330 (or one or more components 360 mounted thereon).

In some embodiments, thermal pad 320 may adhere to heat transfer device 340. In some embodiments, thermal pad 320 may adhere to circuit board 330. In some embodiments, thermal pad 320 may adhere to one or more components 360 mounted on either primary side 331 or secondary side 332 of circuit board 330. In some embodiments, thermal pad 320 may be constructed of a thermally conductive solid material (e.g., thermally conductive foam). In some embodiments, thermal pad 320 may be constructed of a thermally conductive liquid-based, or liquid-suspension material (e.g., thermally conductive paste). In some embodiments, thermal transfer component 320 may be constructed of a thermal interface material, such as thermally conductive adhesives, thermal greases, phase change materials, thermal tapes, thermal epoxies and so forth. In many embodiments, thermal pad 320 may be electrically non-conductive. In some embodiments, thermal pad 320 may be electrically insulating. In some embodiments, a thermal pad, such as thermal pad 320, may be positioned between a component 360 and an interior surface of heat transfer device 340.

In some embodiments, components 360 may be mounted to both primary side 331 and secondary side 332 of circuit board 330. In many embodiments, components may be encased in packaging (e.g., ceramic, metallic materials, etc.) and may include one or more dice. In some embodiments, component packaging may have a high thermal energy transfer coefficient. In most embodiments, component 360 packaging may have electrical connections (e.g., leads or electrical pads) that may configure components 360 to electrically and/or physically couple to circuit board 330. In some embodiments, component 360 packaging may have any number of shapes or sizes. In some embodiments, component 360 packaging may have any z-height dimension (e.g., orthogonal to the circuit board 330) with respect to circuit board 330. In some embodiments, multiple components' 360 packaging may have the same z-height dimension with respect to circuit board 330. In some embodiments, shapes, sizes, and dimensions of multiple components' 360 packaging may be varied (e.g., one component may have one shape, size, and z-height dimension, and another component may have another shape, size, and z-height dimension etc.). In some embodiments, controller 361 may be mounted to primary side 331 of circuit board 330. In some embodiments, controller 361 may be mounted to secondary side 332 of circuit board 330. In some embodiments, a controller 361 may be mounted on each of both primary side 331, and secondary side 332 of circuit board 330.

In some embodiments, an interior surface of heat transfer device 340, such as fourth portion 224 of interior surface 220 as described with respect to **FIG. 2A-2B****,** may be configured to mechanically and/or thermally couple to a top surface of component 360 mounted to primary side 331 of circuit board 330. In some embodiments, another interior surface of heat transfer device 340, such as fifth portion 225 of interior surface 220 as described with respect to **FIG. 2A-2B****,** may be configured to mechanically and/or thermally couple to a top surface of component 360 mounted to secondary side 332 of circuit board 330. In some embodiments, fourth portion 224 of interior surface 220 may be configured to sit adjacent to circuit board 330. In some embodiments, a part of heat transfer device 340, such as middle part 243 of heat transfer device 200 as described with respect to **FIG. 2A-2B****,** may thermally contact (e.g., directly, or indirectly) circuit board 330. In some embodiments, an upper part of heat transfer device 340, such as upper part 241 of heat transfer device 200 as described with respect to **FIG. 2A-2B****,** may extend from middle part 243 at least as far as a distal edge of component 360 or another similar feature mounted to circuit board 330. In some embodiments, upper part 241 may extend at least across the width of a top surface of component 360 mounted to a circuit board 330. In some embodiments, a lower part of heat-transfer device 340, such as lower part 242 of heat transfer device 200 as described with respect to **FIG. 2A-2B****,** may extend as far as a distal edge of a component 360 or similar feature mounted to secondary side 332 of circuit board 330. In some embodiments, lower part 242 may extend at least across the width of a top surface of a component 360 or another similar feature mounted to secondary side 332 of circuit board 330. In some embodiments, heat transfer device 340 may couple to components 360 with a thermal pad, similar to thermal pad 320. In some embodiments, a thermal pad similar to thermal pad 320 may sit adjacent to a top surface of component 360 and an interior surface of heat transfer device 340, such as interior surface 220 of heat transfer device 200 as described with respect to **FIG. 2A-2B****.** In some embodiments, the thermal pad similar to thermal pad 320, may sit atop multiple components 360 of differing z-heights.

In many embodiments, the enclosure envelope of top enclosure 310 and/or bottom enclosure 350 may be constructed to comply with various industry standards (e.g., Serial AT Attachment (SATA)2.5", 3.5", and 5.25"; M.2 Non-Volatile Memory Express (NVMe), and SATA 2242, 2260, and 2280; Mini-SATA (mSATA); Half-Slim SATA or SlimSATA; Enterprise & Datacenter SSD Form Factors (EDSFF) E1.L, E1.S, E2.L, E2.S, E3.L and E3.S; other form factors developed by the Storage Networking Industry Association SSD Form Factor Technical Affiliate (SNIA-SFF-TA); add-in cards and various removable storage form factors; and Peripheral Component Interconnect Express (PCIe) components and other similar computer interface industry form factors).

In some embodiments, top enclosure 310 and bottom enclosure 350 may be constructed from one or a mix of metallic materials (e.g., copper, titanium, aluminum, and/or magnesium). In some embodiments, top enclosure 310 and bottom enclosure 350 may be constructed from one or a mix of non-metallic materials (e.g., semiconductor materials, carbon-based materials, and/or plastics). In some embodiments, top enclosure 310 and bottom enclosure 350 may be constructed from a mix of thermally conductive metallic and non-metallic materials.

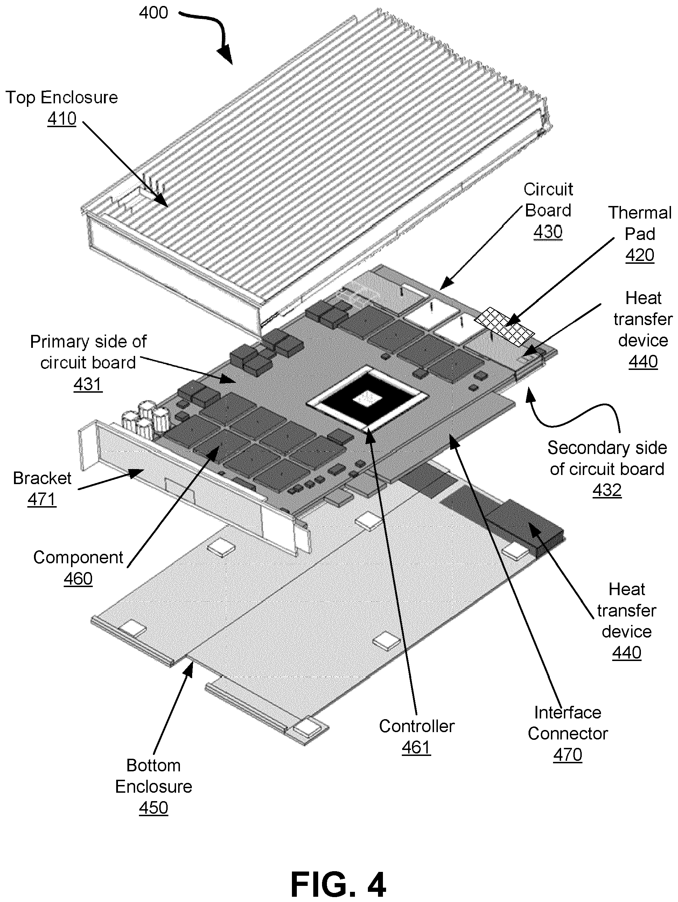

**FIG. 4** illustrates an example embodiment of system 400 with heat transfer devices 440, in accordance with some embodiments. System 400 includes top enclosure 410, thermal pad 420, circuit board 430, heat transfer device 440, bottom enclosure 450, and bracket 471. Interface connector 470 is part of circuit board 430. For clarity, **FIG. 4** illustrates a semi-exploded view of system 400, with the same heat transfer device 440 labeled twice; above, to show the position of heat transfer device 440 with respect to top enclosure 410, thermal pad 420, and circuit board 430, and again below, to show the position of heat transfer device 440 with respect to bottom enclosure 450 when circuit board 430 has been removed from bottom enclosure 450. Bracket 471 is mechanically attached to circuit board 430, and may also be electrically attached to circuit board 430. Circuit board 430 has a primary side 431, and a secondary side 432. Components 460 are mechanically, and often electrically, attached to circuit board 430. Controller 461 is a certain component 460, and in the example embodiment, is mounted to primary side 431. Heat transfer devices 440 may be a heat transfer device such as heat transfer device 200 as described with respect to **FIG. 2A-****2B.** Heat transfer device 440 mechanically and thermally couples to components 460. Heat transfer device 440 mechanically and thermally couples to top enclosure 410 and bottom enclosure 450. Thermal pad 420 contacts heat transfer device 440 and top enclosure 410. In some embodiments, the location of interface connector 470 and bracket 471 may be determined by an industry standard. In some embodiments, system 400 may be a system such as system 300 as described with respect to **FIG. 3****.**

In most embodiments, components 460 may be mounted to primary side 431 of circuit board 430. In most embodiment, minor components 460 (e.g., small capacitors, resistors, low profile surface mount device (SMD) components, etc.) may be mounted to secondary side 432. In many embodiments, system 400 may improve the uniform distribution of thermal energy (e.g., heat) generated by components 460 mounted to primary side 431 to both top enclosure 410 and bottom enclosure 450. In many embodiments, industry standard form factors may greatly restrict the z-height tolerance for components 460 mounted on secondary side 432 in comparison to the z-height tolerance for components 460 mounted on primary side 431 of circuit board 430. In some embodiments, low power (e.g., low thermal energy generating) components 460 may be mounted to secondary side 432 of circuit board 430. In some embodiments, components 460 may not be mounted to secondary side 432 of circuit board 430. In some embodiments, the amount of thermal energy generated by components 460 mounted to secondary side 432 of circuit board 430 may be lower than the amount of thermal energy generated by components 460 mounted to primary side 431 of circuit board 430. In some embodiments, bottom enclosure 450 may be a metal backing, or protective plate. In some embodiments, bottom enclosure 450 may be thermally coupled to heat transfer device 440. In some embodiments, heat transfer device 440 may be thermally coupled to components 460 mounted to primary side 431. In some embodiments, heat transfer device 440 may be configured to transfer thermal energy generated by components 460 mounted to primary side 431 to bottom enclosure 450. In some embodiments, bottom enclosure 450 may be configured as a heatsink. In some embodiments, top enclosure 410 may be thermally and/or mechanically coupled to a heatsink. In some embodiments, top enclosure 410 may be configured as a heatsink. In some embodiments, components 460 mounted to primary side 431 of circuit board 430 may transfer thermal energy from primary side 431 of circuit board 430 or top enclosure 410 to bottom enclosure 450. In some embodiments, bottom enclosure 450 may increase the effective surface area available to system 400 to dissipate thermal energy generated by components 460 mounted to primary side 431 of circuit board 430.

In some embodiments, bottom enclosure 450 may thermally and/or mechanically couple to heat transfer device 440. In certain embodiments, thermal pad 420 may thermally couple bottom enclosure 450 to heat transfer device 440. In some embodiments, bottom enclosure 450 may be detachably connected to heat transfer device 440. In some embodiments, heat transfer device 440 may be a permanent fixture of top enclosure 410 and/or bottom enclosure 450.

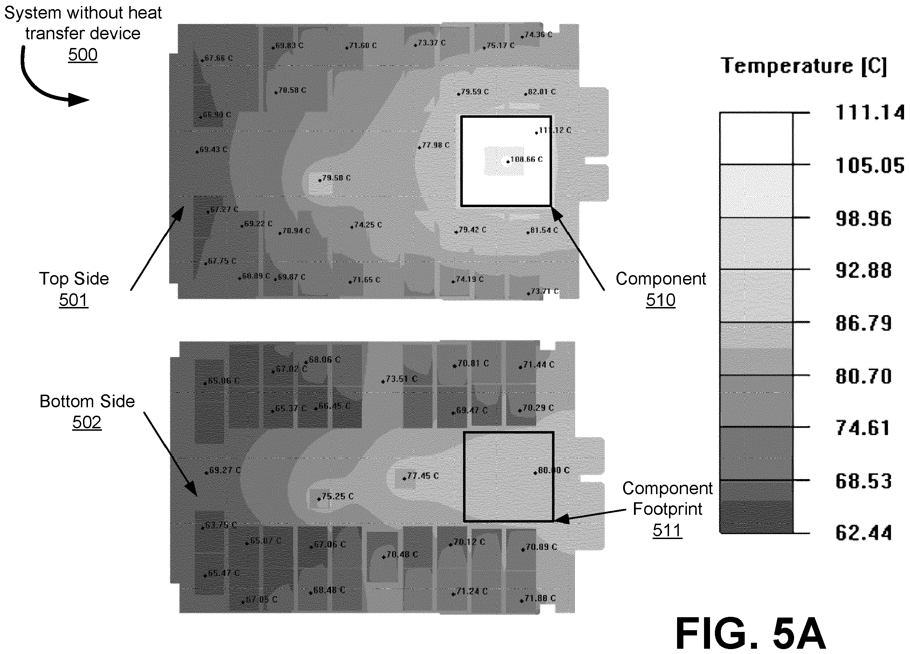

**FIG. 5A** illustrates thermal scans of an example system in operation without implementing a heat transfer device, in accordance with some embodiments. Top side 501 of system 500 near component 510 shows an isolated high level of thermal energy (e.g., heat) approaching 111. 14°C. Further from component 510 on top side 501 of shows low levels of thermal energy approaching 62.44°C. Bottom side 502 near component footprint 511 (e.g., the reverse side of component 510) shows a high level of thermal energy approaching 80.80°C. Other areas on bottom side 502 of system show a low level of thermal energy approaching 62.44°C. The thermal scans of system 500 show a large thermal energy differential between localized spots of high thermal energy and areas of low thermal energy.

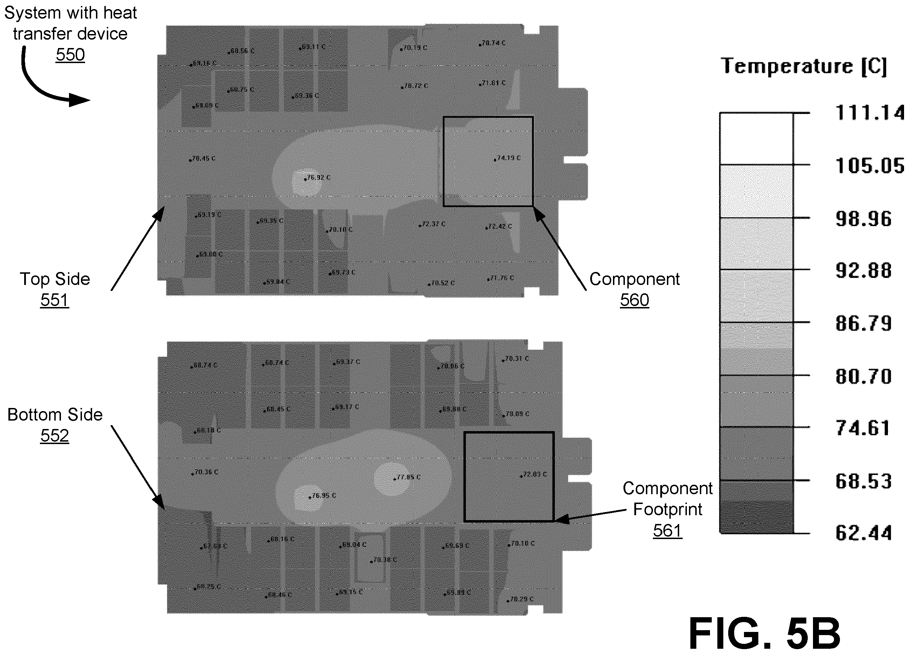

**FIG. 5B** illustrates thermal scans of an example system in operation with a heat transfer device, in accordance with some embodiments. Top side 551 of system 550, near component 560 shows a high level of thermal energy (e.g., heat) approaching 74.61°C. Further away from component 560 shows low levels of thermal energy approaching 68.53°C. Bottom side 552 near component footprint 561 (e.g., near the reverse side of component 560) shows a high level of thermal energy approaching 80.70°C. Other areas on bottom side 552 show a low level of thermal energy approaching 68.53°C. The thermal scans of system 550 show a smaller and improved thermal energy differential (e.g., a more uniformly spread thermal energy load) compared with the thermal scans of system 500 as described with respect to **FIG. 5A****.**

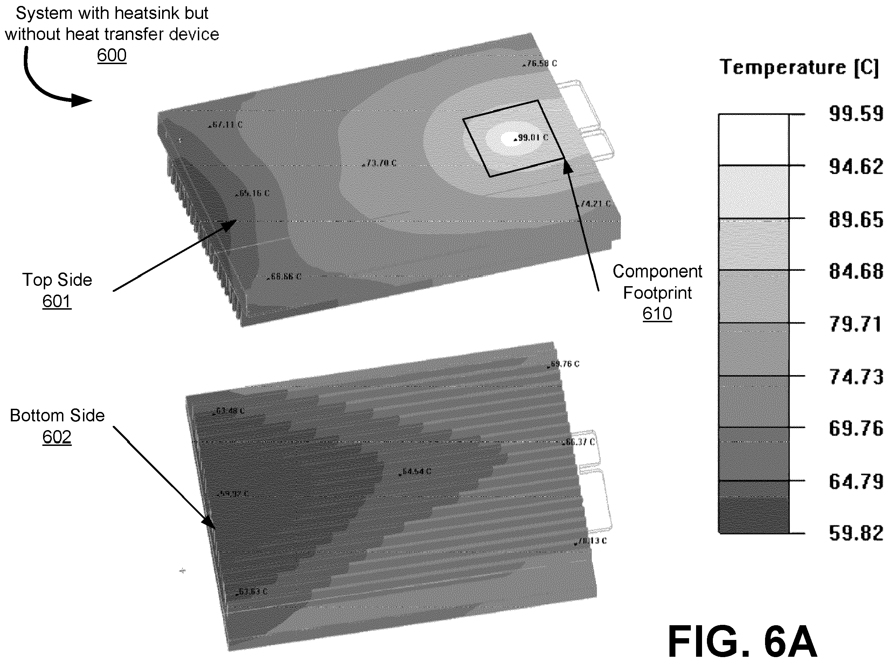

**FIG. 6A** illustrates thermal scans of an example system in operation with a heatsink, but without a heat transfer device, in accordance with some embodiments. Top side 601 of system 600 near component footprint 610 shows an isolated high level of thermal energy (e.g., heat) approaching 99.59°C. Further from component footprint 610 on top side 601 shows low levels of thermal energy approaching 59.82°C. Bottom side 602 of system 600 shows a high level of thermal energy approaching 74.73°C. Other areas on bottom side 602 of system 600 show a low level of thermal energy approaching 59.82°C. The thermal scans of system 600 show a large thermal energy differential between localized spots of high thermal energy and areas of low thermal energy.

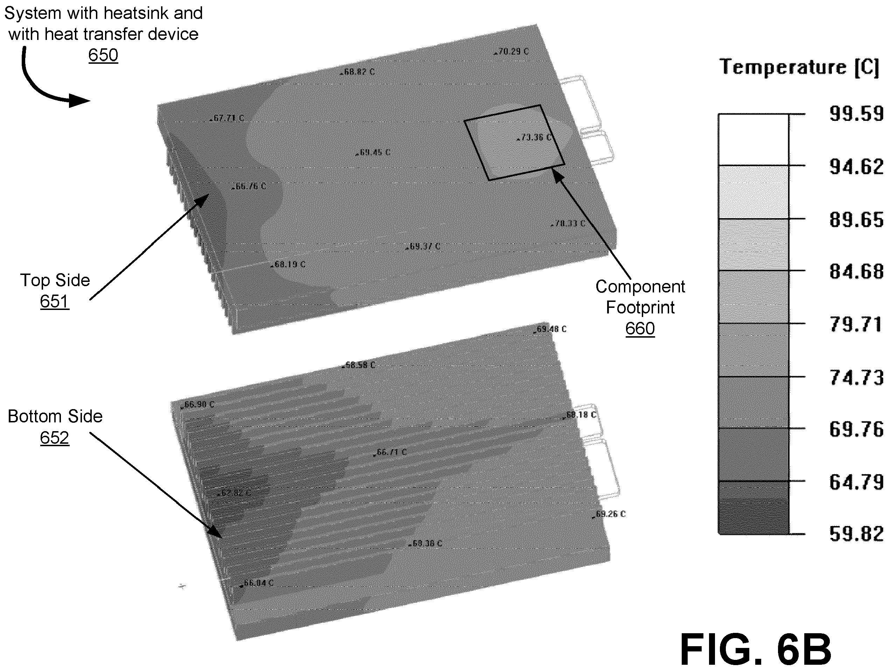

**FIG. 6B** illustrates thermal scans of an example system in operation with a heatsink and a heat transfer device, in accordance with some embodiments. Top side 651 of system 650 near component footprint 660 shows a high level of thermal energy (e.g., heat) approaching 74.73°C. Further from component footprint 660 on top side 651 shows low levels of thermal energy approaching 64.79°C. Bottom side 652 shows a high level of thermal energy approaching 69.76°C. Other areas on bottom side 652 show a low level of thermal energy approaching 59.82°C. The thermal scans of system 650 show a smaller and improved thermal energy differential (e.g., a more uniformly spread thermal energy load) compared with the thermal scans of system 600 as described with respect to **FIG. 6A****.**

Some portions of the preceding detailed descriptions have been presented in terms of algorithms and symbolic representations of operations on data bits within a computer memory. These algorithmic descriptions and representations are the ways used by those skilled in the data processing arts to most effectively convey the substance of their work to others skilled in the art. An algorithm is here, and generally, conceived to be a self-consistent sequence of operations leading to a desired result. The operations are those requiring physical manipulations of physical quantities. Usually, though not necessarily, these quantities take the form of electrical or magnetic signals capable of being stored, combined, compared, and otherwise manipulated. It has proven convenient at times, principally for reasons of common usage, to refer to these signals as bits, values, elements, symbols, characters, terms, numbers, or the like.

It should be borne in mind, however, that all of these and similar terms are to be associated with the appropriate physical quantities and are merely convenient labels applied to these quantities. The present disclosure can refer to the action and processes of a computer system, or similar electronic computing device, that manipulates and transforms data represented as physical (electronic) quantities within the computer system's registers and memories into other data similarly represented as physical quantities within the computer system memories or registers or other such information storage systems.

The algorithms and displays presented herein are not inherently related to any particular computer or other apparatus. Various general purpose systems can be used with programs in accordance with the teachings herein, or it can prove convenient to construct a more specialized apparatus to perform the method. The structure for a variety of these systems will appear as set forth in the description below. In addition, the present disclosure is not described with reference to any particular programming language. It will be appreciated that a variety of programming languages can be used to implement the teachings of the disclosure as described herein.

In the foregoing specification, embodiments of the disclosure have been described with reference to specific example embodiments thereof. It will be evident that various modifications can be made thereto without departing from the broader spirit and scope of embodiments of the disclosure as set forth in the following claims. The specification and drawings are, accordingly, to be regarded in an illustrative sense rather than a restrictive sense.

Further embodiments are set out in the following clauses:
1. A system comprising:
   a circuit board comprising a plurality of components;
   an enclosure comprising a top portion and a bottom portion, the enclosure configured to enclose at least a part of the circuit board; and
   a first heat transfer device, comprising:
      an exterior surface comprising a first portion, a second portion, and a third portion located between the first portion and the second portion, wherein the first portion faces opposite the second portion; and
      an interior surface comprising a fourth portion, a fifth portion, and a sixth portion located between the fourth portion and the fifth portion, wherein the fourth portion faces the fifth portion,
      wherein the first portion of the exterior surface is configured to thermally couple to the top portion of the enclosure,
      wherein the second portion of the exterior surface is configured to thermally couple to the bottom portion of the enclosure,
      wherein the fourth portion of the interior surface is configured to couple to a first electrical component of the plurality of components, the first electrical component mounted on a primary side of the circuit board, and
      wherein the fifth portion of the interior surface is configured to face a secondary side of the circuit board, the first heat transfer device configured to distribute a portion of thermal energy generated from at least the first electrical component to the top portion and the bottom portion of the enclosure.
2. The system of clause 1,
   wherein the fourth portion of the interior surface is configured to couple to at least a second electrical component of the plurality of components, the at least second electrical component mounted on the primary side of the circuit board.
3. The system of clause 1,
   wherein the fifth portion of the interior surface is configured to couple to at least a third electrical component of the plurality of components, the third electrical component mounted on the secondary side of the circuit board.
4. The system of clause 1,
   wherein the fifth portion of the interior surface is directly uncoupled from any of the plurality of components of the circuit board.
5. The system of clause 1, further comprising:
   a first thermal pad located between the exterior surface of the first heat transfer device and the top portion of the enclosure, and configured to thermally couple the exterior surface of the first heat transfer device and the top portion of the enclosure.
6. The system of clause 1, further comprising:
   a second thermal pad located between the interior surface of the first heat transfer device and a top surface of at least the first electrical component of the plurality of components, and configured to thermally couple the interior surface of the first heat transfer device and the top surface of the first electrical component of the plurality of components.
7. The system of clause 1, wherein the exterior surface of the first heat transfer device is a first exterior surface, wherein the interior surface of the first heat transfer device is a first interior surface, the system further comprising:
   a second heat transfer device, comprising:
   a second exterior surface comprising a seventh portion, an eighth portion, and a ninth portion located between the seventh portion and the eighth portion, wherein the seventh portion faces opposite the eighth portion; and
   a second interior surface comprising a tenth portion, an eleventh portion, and a twelfth portion located between the tenth portion and the eleventh portion, wherein the tenth portion faces the eleventh portion,
   wherein the seventh portion of the second exterior surface is configured to thermally couple to the top portion of the enclosure,
   wherein the eighth portion of the second exterior surface is configured to thermally couple to the bottom portion of the enclosure,
   wherein the tenth portion of the second interior surface is configured to thermally couple to a second electrical component of the plurality of components, the second electrical component mounted on the primary side of the circuit board, and
   wherein the eleventh portion of the second interior surface is configured to face the secondary side of the circuit board, the second heat transfer device configured to distribute a portion of thermal energy generated from at least the second electrical component to the top portion and the bottom portion of the enclosure.
8. The system of clause 1,
   wherein the fourth portion of the interior surface is configured to extend over a top surface of the first electrical component of the plurality of components; and
   wherein the fifth portion of the interior surface is substantially symmetric to the fourth portion about an axis bisecting the sixth portion.
9. The system of clause 1,
   wherein the fourth portion of the interior surface is configured to extend over a top surface of the first electrical component of the plurality of components, and
   wherein the fifth portion of the interior surface is asymmetric to the fourth portion about an axis bisecting the sixth portion.
10. The system of clause 1, wherein the top portion of the enclosure comprises a heatsink with one or more fins.
11. The system of clause 1, wherein the first electrical component is a non-volatile memory device.
12. An apparatus comprising:
   a first heat transfer device, comprising:
   an exterior surface comprising a first portion, a second portion, and a third portion located between the first portion and the second portion, wherein the first portion faces opposite the second portion; and
   an interior surface comprising a fourth portion, a fifth portion, and a sixth portion located between the fourth portion and the fifth portion, wherein the fourth portion faces the fifth portion,
   wherein the first portion of the exterior surface is configured to thermally couple to a top portion of an enclosure of a circuit board comprising a plurality of components,
   wherein the second portion of the exterior surface is configured to thermally couple to a bottom portion of the enclosure,
   wherein the fourth portion of the interior surface is configured to thermally couple to a first electrical component of the plurality of components, the first electrical component mounted on a primary side of the circuit board, and
   wherein the fifth portion of the interior surface is configured to face a secondary side of the circuit board, the first heat transfer device configured to distribute a portion of thermal energy generated from at least the first electrical component to the top portion and the bottom portion of the enclosure.
13. The apparatus of clause 12,
   wherein the fourth portion of the interior surface is configured to thermally couple to at least a second electrical component of the plurality of components, the at least second electrical component mounted on the primary side of the circuit board.
14. The apparatus of clause 12,
   wherein the fifth portion of the interior surface is configured to thermally couple to at least a third electrical component of the plurality of components, the third electrical component mounted on the secondary side of the circuit board.
15. The apparatus of clause 12,
   wherein the fifth portion of the interior surface is directly uncoupled from any of the plurality of components of the circuit board.
16. The apparatus of clause 12,
   wherein the first portion of the exterior surface that is configured to thermally couple to the top portion of the enclosure is configured to transfer the thermal energy and the second portion of the exterior surface that is configured to thermally couple to the bottom portion of the enclosure are configured to transfer thermal energy via thermal conduction.
17. The apparatus of clause 12, wherein the exterior surface of the first heat transfer device is a first exterior surface, wherein the interior surface of the first heat transfer device is a first interior surface, the apparatus further comprising:
   a second heat transfer device, comprising:
   a second exterior surface comprising a seventh portion, an eighth portion, and a ninth portion located between the seventh portion and the eighth portion, wherein the seventh portion faces opposite the eighth portion; and
   a second interior surface comprising a tenth portion, an eleventh portion, and a twelfth portion located between the tenth portion and the eleventh portion, wherein the tenth portion faces the eleventh portion,
   wherein the seventh portion of the second exterior surface is configured to thermally couple to the top portion of the enclosure,
   wherein the eighth portion of the second exterior surface is configured to thermally couple to the bottom portion of the enclosure,
   wherein the tenth portion of the second interior surface is configured to thermally couple to a second electrical component of the plurality of components, the second electrical component mounted on the primary side of the circuit board, and
   wherein the eleventh portion of the second interior surface is configured to face the secondary side of the circuit board, the second heat transfer device configured to distribute a portion of thermal energy generated from at least the second electrical component to the top portion and the bottom portion of the enclosure.
18. The apparatus of clause 12,
   wherein the fourth portion of the interior surface is configured to extend over a top surface of the first electrical component of the plurality of components; and
   wherein the fifth portion of the interior surface is substantially symmetric to the fourth portion about an axis bisecting the sixth portion.
19. The apparatus of clause 12,
   wherein the fourth portion of the interior surface is configured to extend over a top surface of the first electrical component of the plurality of components, and
   wherein the fifth portion of the interior surface is asymmetric to the fourth portion about an axis bisecting the sixth portion.
20. The apparatus of clause 12,
   wherein the first heat transfer device comprises at least one of titanium or graphite.

## Claims

1. An apparatus comprising:
a first heat transfer device, comprising:
an exterior surface comprising a first portion, a second portion, and a third portion located between the first portion and the second portion, wherein the first portion faces opposite the second portion; and
an interior surface comprising a fourth portion, a fifth portion, and a sixth portion located between the fourth portion and the fifth portion, wherein the fourth portion faces the fifth portion,
wherein the first portion of the exterior surface is configured to thermally couple to a top portion of an enclosure of a circuit board comprising a plurality of components,
wherein the second portion of the exterior surface is configured to thermally couple to a bottom portion of the enclosure,
wherein the fourth portion of the interior surface is configured to thermally couple to a first electrical component of the plurality of components, the first electrical component mounted on a primary side of the circuit board, and
wherein the fifth portion of the interior surface is configured to face a secondary side of the circuit board, the first heat transfer device configured to distribute a portion of thermal energy generated from at least the first electrical component to the top portion and the bottom portion of the enclosure.

2. The apparatus of claim 1,
wherein the fourth portion of the interior surface is configured to thermally couple to at least a second electrical component of the plurality of components, the at least second electrical component mounted on the primary side of the circuit board.

3. The apparatus of either of claims 1 or 2,
wherein the fifth portion of the interior surface is configured to thermally couple to at least a third electrical component of the plurality of components, the third electrical component mounted on the secondary side of the circuit board.

4. The apparatus of either of claims 1 or 2,
wherein the fifth portion of the interior surface is directly uncoupled from any of the plurality of components of the circuit board.

5. The apparatus of any preceding claim,
wherein the first portion of the exterior surface that is configured to thermally couple to the top portion of the enclosure is configured to transfer the thermal energy and the second portion of the exterior surface that is configured to thermally couple to the bottom portion of the enclosure are configured to transfer thermal energy via thermal conduction.

6. The apparatus of claim 1, wherein the exterior surface of the first heat transfer device is a first exterior surface, wherein the interior surface of the first heat transfer device is a first interior surface, the apparatus further comprising:
a second heat transfer device, comprising:
a second exterior surface comprising a seventh portion, an eighth portion, and a ninth portion located between the seventh portion and the eighth portion, wherein the seventh portion faces opposite the eighth portion; and
a second interior surface comprising a tenth portion, an eleventh portion, and a twelfth portion located between the tenth portion and the eleventh portion, wherein the tenth portion faces the eleventh portion,
wherein the seventh portion of the second exterior surface is configured to thermally couple to the top portion of the enclosure,
wherein the eighth portion of the second exterior surface is configured to thermally couple to the bottom portion of the enclosure,
wherein the tenth portion of the second interior surface is configured to thermally couple to a second electrical component of the plurality of components, the second electrical component mounted on the primary side of the circuit board, and
wherein the eleventh portion of the second interior surface is configured to face the secondary side of the circuit board, the second heat transfer device configured to distribute a portion of thermal energy generated from at least the second electrical component to the top portion and the bottom portion of the enclosure.

7. The apparatus of any preceding claim,
wherein the fourth portion of the interior surface is configured to extend over a top surface of the first electrical component of the plurality of components; and
wherein the fifth portion of the interior surface is substantially symmetric to the fourth portion about an axis bisecting the sixth portion.

8. The apparatus of any of claims 1 to 6,
wherein the fourth portion of the interior surface is configured to extend over a top surface of the first electrical component of the plurality of components, and
wherein the fifth portion of the interior surface is asymmetric to the fourth portion about an axis bisecting the sixth portion.

9. The apparatus of any preceding claim,
wherein the first heat transfer device comprises at least one of titanium or graphite.

10. A system comprising:
a circuit board comprising a plurality of components;
an enclosure comprising a top portion and a bottom portion, the enclosure configured to enclose at least a part of the circuit board; and
an apparatus according to any preceding claim.

11. The system of claim 10, further comprising:
a first thermal pad located between the exterior surface of the first heat transfer device and the top portion of the enclosure, and configured to thermally couple the exterior surface of the first heat transfer device and the top portion of the enclosure.

12. The system of claim 10, further comprising:
a second thermal pad located between the interior surface of the first heat transfer device and a top surface of at least the first electrical component of the plurality of components, and configured to thermally couple the interior surface of the first heat transfer device and the top surface of the first electrical component of the plurality of components.

13. The system of claim 10, wherein the top portion of the enclosure comprises a heatsink with one or more fins.
